# EUROPEAN PATENT SPECIFICATION

(11) **EP 3 584 137 B1**
(45) Date of publication and mention of the grant of the patent: **22.10.2025**
(21) Application number: 19466004.9
(22) Date of filing: 23.04.2019
(51) Int. Cl.: B61F 5/30, B61F 5/32, B61F 5/52

(54) **RAILWAY BOGIE, IN PARTICULAR FOR FREIGHT CAR**
EISENBAHNDREHGESTELL, INSBESONDERE FÜR GÜTERWAGEN
BOGIE FERROVIAIRE, EN PARTICULIER POUR WAGON DE MARCHANDISES

(30) Priority: 19.06.2018 CZ 20180029
(43) Date of publication of application: 25.12.2019
(73) Proprietor: VÚKV a.s., 158 00 Praha 5 (CZ)
(72) Inventor: Capek, Jan, 19800 Praha 9 (CZ); Bauer, Petr, 17000 Praha 7 (CZ); Fridrichovsky, Tomas, 58601 Jihlava (CZ); Heptner, Tomas, Praha 6 (CZ); Malkovsky, Zdenek, 16000 Praha 6 (CZ); Mourecek, Zdenek, 26727 Liten (CZ); Musil, Jan, 53361 Choltice (CZ); Phamová, Lucie, Odolena Voda (CZ); Ziskal, Tomas, 26705 Nizbor (CZ); Krulich Pavel, 182 00 Praha 8 (CZ)
(74) Representative: Loskotová, Jarmila

(56) References cited:
- EP-A1- 0 182 339
- EP-A1- 2 386 454
- EP-A2- 0 234 357
- WO-A1-2015/159085
- CA-A- 1 151 221
- FR-A1- 2 575 429

## Description

### The field of technology

The presented invention relates to a railway bogie especially freight car bogie, specifically design of a bogie suspension, design of a bogie frame and bolster arrangement. There are defined considerable requirements on freight cars and freight car bogies. A huge difference between the mass of the empty car and the mass of the fully loaded car is significant in freight car operation - the full loaded vehicle may be six times heavier than the empty one. Safety relevant requirements must be kept over the whole load range. It is especially safety against derailment and request on stable ride. To keep the safety against derailment is necessary to ensure that the change of the wheel load difference caused due to ride through elevation ramp (twisted track) does not exceed the limit value defined in the relevant standard. To fulfil these requirements the car has to be equipped with a suspension characterised by a load dependent stiffness. The empty car shall have a low stiffness vice versa the fully loaded car has a high stiffness which prevents to exceed the limits for the car buffers vertical movement. The suspension of current freight bogies deals with characteristics built from two different linear stiffnesses, crossing each to other in so called switch point. This solution cause problems with vehicle running behaviour when they are loaded near to switch point load in operation.

Particularly, recently produced freight cars equipped with a long and low tare vehicle body deal problems to keep the limit of wheel force change on twisted track. It is favourable to use a torsion-flexible bogie frame, or three pieces bogie frame to minimize the wheel force changes. These arts of bogie frames are not used in current European standardised freight car bogies.

Disadvantage of out of Europe most spread freight car bogies with three piece bogie frame, is a serious problem of a small bogie warp stiffness which leads to bogie warping. It is a phenomenon when one bogie side frame overtakes the other one in the curve, thereby the wear of the wheel and rail in the curve is significant higher. Small warping stiffness also leads to an unstable ride of the vehicle in a straight track ("hunting"). The freight bogies have to be stable in every state i.e. in any load of the vehicle and at any operation velocity. The unstable vehicle ride leads to risk of excessive wear of the car and track and may lead to an accident. The simplest way, how to reach stable ride of the vehicle, is to use a rigid bogie frame and rigid wheelset guidance. Vehicle ride stability is to be improve by decreasing of bogie inertia towards the vertical axis, i.e. with concentration of bogie masses as close to the bogie centre as possible. The suspension design of current European standardized freight bogies significantly exceeds the axle distance - the wheelbase. It is suitably to minimize freight bogie dimensions, especially length of the bogie and bogie height in wheel surround. Bogies with reduced dimensions have advantage to offer more space for design of the vehicle body structure. So is possible to better optimize design of the vehicle body structure and decrease its mass.

It is also suitable to minimize unsprung masses of the bogie. High value of unsprung masses leads to fast wear of wheels, bearings and track.

The worldwide most widespread freight bogie designs are equipped with spring sets that cause a step ramp change of the suspension stiffness. Single springs joint one by one to carry the load with increasing the whole vehicle load. This causes clattering of unloaded springs, which leads to increased noise emission of running vehicles. Freight cars, approved for operation in Europe, have given limits of noise pollution. A more strict noise restriction is expected in a short future. Reduction of noise pollution can be achieved via cutting off the metal - metal interfaces on the vibration way from wheelset to vehicle body. The most effective solution is to insert a rubber part with a sufficient rubber volume into the suspension Current standard freight bogies design does not fit the usage of rubber elements in an efficient way. Other possibility to reduce the noise pollution is a suspension design with permanently loaded springs, this prevent the clapping of the not loaded springs.

The suspension of freight bogies has to be equipped with dampers to ensure the required ride quality. The damping force shall be proportional to the vehicle load acting on the suspension in every load state. The best way to meet this requirement at freight cars is to use a friction damper where the damp force is mechanically derived from sprung mases of the vehicle.

Current friction damping systems of standard bogies has so high damping effect at empty vehicles - so called hysteresis of the suspension - which disables the suspension when vehicle is running on the track with good geometrical quality. This suspension malfunction at empty cars or in partially loaded cars leads to undesirable bending oscillations of vehicle body. This oscillation increase the degree of utilization of all vehicle body parts and increase dynamic forces between the vehicle and track.

There are freight bogies designed for velocities over 120 km/h in operation in Europe. These bogies are equipped with improved lateral suspension in comparison to standard bogies. In the suspension is add a bolster supported by a set of swing links. Bolster implementation requires a large wheel base, which is associated with bogie mass increase and requires more space under car body for the bogie.

Design of freight car bogies has to be simple, highly reliable allowing long maintenance intervals, easily maintainable and especially cheap. The freight car bogie design must meet standards relevant for infrastructure in which the bogies operate. These standards for Europe are EN and UIC.

It is evident from the above mentioned that requirements on the freight car bogie design are contradictory. It is difficult to fulfil one requirement when another - conflict - requirement is met in an optimal way.

### The prior art

The most widespread freight bogie of standard type in Europe is bogie called Y25, e.g. patent file EP1057707 A1. The suspension consists of sets of helical steel springs. The damping provides friction plunger whose compressive force between bogie frame and axle box derives from the suspended mass of the vehicle via inclined link. This design leads to a block of the suspension due to high friction hysteresis when the vehicle is running on track with good geometrical quality. The suspension is arranged between wheelset and bogie frame. The bogie has a rigid welded bogie frame so the bogie does not warp passing the curve. On the other hand, the bogie frame is not torsional flexible which causes problems with change of the wheel forces on twisted track at empty or at partially loaded cars of small tare weight. The bogie suspension dimensions exceed the length over axle boxes, which makes the bogie bigger and increases its inertia momentum around the vertical axis. Internal springs are unloaded to the load of the car equal to switch point. The unloaded springs are source of the noise pollution.

Required bogie height is achieved via a sorting of springs according to test spring height results, where every spring set must fit into required combination. This increases necessary number of stored and maintained springs. In case of wheel reprofilation are shims mounted between the upper pivot bearing and vehicle body and between side bearer supports and vehicle body (according to UIC). The shim setting requires bogie dismounting from car body and to lift car body by lifting jacks.

The Y25 bogie is approved for maximum operating speed 120 km/h. To perform higher speeds, the design of the bogie must be improved by adding a bolster. This bolster is arranged on set of swing links. This type of bogie is labelled as Y37 bogie. In comparison to Y25 bogie is Y37 troubled with following disadvantages - the bogie has significantly enlarged wheelbase, which lead to increased wheel wear and increased length of the bogie, which influences the design of the vehicle body.

One of the oldest and most widespread freight car bogies is a bogie equipped with leaf springs. A design of this bogie is standardised in Europe too. Leaf spring suspension is arranged between wheelset and bogie frame. The bogie has a rigid welded bogie frame, i.e. the bogie does not warp when passing the curve. On the other hand, the bogie frame is not torsional flexible which causes problems with change of the wheel forces on twisted track at empty or at partially loaded cars of small tare weight. It is possible to equip the bogie with an equalising beam mechanism on one bogie side between adjacent leaf spring hangers. This equalising beam decreases undesirable changes of wheel forces but this solution requires more joints and parts that suffer on friction wear in suspension. The damping of the bogie is performed via friction between spring leafs. This causes malfunction of the suspension when the empty vehicle is running on track with good geometrical quality. Friction effect has a great scatter due to condition of spring leaf surface, which is problematic for empty or partly loaded vehicles. Length of the suspension significant exceeds the length over axle boxes and makes the bogie significantly long. The bogie frame is heavy and it has a high inertia. Leaf springs are expensive to in production and maintenance. Steel links of leaf springs increases noise emissions of the bogie. The bogie is unstable at higher standardised velocities. In case of wheel reprofilation, the shims are arranged between axle boxes and leaf springs clip (according to UIC), which installation requires demounting of the wheelsets and to lift the vehicle body with a lifting jack.

Another and the oldest freight car bogie design is a bogie called "three pieces bogie", also called "Diamond Bogie/Truck", see patent file EP0182339A1, US 2,170,862 and US 3,717,106 A. This is the most widespread bogie worldwide for the sake of its cheapness. The bogie operates in Europe in a small number due to its some negative properties. The suspension is located between side frames and bolster. Non suspended side frames are mounted on the axle boxes via adapters. This significantly increases amount of unsprung masses. The bogie frame consists of two side frames and one movably assembled bolster. The bogie has a good torsion flexibility that decreases change of the wheel forces when vehicle is running on twisted track. The warp stiffness of the bogie is small, that limits the operation velocity to ca. 80 km/h. A friction damper is located between side frames and bolster. Due to the hysteresis the damping causes malfunction of suspension on good quality track. Additional function of damper parts is to prevent from warping. This cause faster wear of this part, consequence is a worse running behaviour of the bogie. Unfortunately, this arrangement does not prevent the warping sufficient. The bogie is equipped with large set of coiled springs. Part of the spring number do not carry the load until certain load of the car. This represents a source of the noise.

In order to improve the above mentioned disadvantages, an innovative design of the bogies has been created. These innovative bogies are not in operation in a significant number.

The bogie with rubber roll elements labelled as a "DRRS bogie" - double rubber roll spring", see patent file EP 0 234 357. The main parts of the suspension are manufactured as rubber rings that are inserted into specific steel structure. The damping provides friction plunger whose compressive force between the bogie frame and the axle box derives from an eccentric arrangement of the rubber rings located one above the other. This design also due to the hysteresis disables a function of dumping when running on good quality track. The bogie is equipped with rigid welded bogie frame that does not warp. The bogie frame is torsion rigid. This causes problems with change of the wheel forces at cars with light vehicle body. The suspension dimensions exceed the axle boxes base, which increase its inertia momentum towards the vertical axis. The flexibility of the suspension provides only the rubber rings. Usage of rubber decreases noise pollution. To ensure the required displacement in suspension, the rubber rings are strained not only by pressure, but additionally by abrasion. The abrasion strain is adverse for rubber and leads to decrease the rubber rings life time.

RC25NT bogie equipped with radial steering of wheelset - radial controlled, new technology, see patent file EP2386454A1. The bogie is equipped with steel helical springs. Suspension and friction damping is arranged between side frames and bolster (very similarly to three pieces bogie). The friction damping provides a lever mechanism. Poor stability of the three pieces bogie concept improve additional brake bracket beams arranged between longitudinal beams and next mechanical link between wheelsets. Nevertheless, this solution significant increases weight and complexity of the bogie.

TF25 bogie - track friendly, see patent file GB2332410 A.

The bogie represents a more complex design due to the two-stage suspension. The second stage of suspension consists of huge rubber springs. The rubber springs reduce noise and ensure rotation of the bogie under car body. Bogie rotation in curve leads to significant shear strain of the spring. Due to placement of the spring in second stage of suspension, the noise reduction is not so much significant as rubber between wheelset and the bogie frame. The damping provide hydraulic dampers, whose damping effect changes only in step change. The damping effect does not change smoothly with the load. Hydraulic dampers are more expensive and less reliably unlike damping provided by a simple friction mechanism. The design of primary suspension leads to a bigger height of the bogie due to sets of vertically oriented helical steel springs arranged above axle boxes. The springs carry load one by one, so the not loaded springs produce noise. The design of bogie frame is simplified by arrangement of longitudinal beam and cross bam which are assembled together through pre-stressed bolts (huck-bolts). The axis of the bolts align the horizontal plane. This means that the connection of bogie frame beams is significantly shear strained by the vehicle weight, which is not optimal for this kind of connection.

A solution to solve conflict between requirement of rigid bogie frame and requirement of torsion-flexible bogie frame describes patent file DE883292C. This solution bases on design of rigid bogie frame and usage of equalising mechanism between springs on one side of the bogie (left or right). The equalising mechanism contains rods that are movable mounted into bogie frame in sliding brackets. On both ends of the rods are arranged helical spring interfaces. Thread on rods provides an adjustment. The rods are equipped with joints and telescopic guidance. Joints and sliding guidance represent more complex design and significant wear of those parts due friction. The friction in sliding guidance is a source of undesirable hysteresis in equalizing mechanism that should substitute torsion flexibility of bogie frame. In the bogie is missing a damping effect depending on the load of the vehicle. Height of the bogie is set up via mechanism that contains adjustable rods and eccentric. Such an overhaul mechanism is a permanent part of the bogie and too complex. Individual parts of the mechanism are heavy due to permanent load by forces acting in the suspension. The reliability of mechanism depends on good function of sliding parts with passive resistance and that function is under risk of corrosion.

A version of previously mentioned solution (see patent file DE883292C) describes patent file EP1767430A1. The equalizing mechanism contains also frictionally guided rods that substitute the torsional flexibility of the bogie frame. Other version of the design according to the EP1767430A1contains a rocker arm that is connected to the bogie frame by a joint. But this joint is strained with a high force that is equivalent to the mass of the car. According to the EP1767430A1 a damper is purposefully a part of this equalising mechanism, but this damper causes increase of undesirable hysteresis in the equalizing mechanism and so increases the undesirable change wheel forces. Also is known the CA 1 151 221 solution comprising a damping and equalizing system which it's complex has a number of specific functional disadvantages. The adjacent bogie structure to this damping system are (additionally to the damping friction forces) more loaded by the pressure (normal) force in the damper. The affected parts are the bogie frame and the swing arm joint. An even higher load is caused by the fact, that there are only one pair of friction surfaces, whereas on the standardised bogies in Europe are two or more pairs of friction surfaces. In the presented arrangement is necessary to implement other parts to compensate the rotational movement of the swing arm which suffer from load and wear - friction shoe with it's pivoting. Fundamental disadvantage is that damping andequalizing functions are interrelated, thus damper damps not only the dynamic movement of the wheel (which is requested) but also prevents or blocks the movement of the equalizer beam, thus devaluing the equalizing effect, which disadvantage is critical for safety against derailment. The entire equalizing system is inherently loaded with braking forces and high percentage of vehicle weight and dynamic, which in consequence makes the system heavier and wears faster and more expensive to operate.

### The gist of invention

The invention aims to remove above mentioned disadvantages and to design bogie for railway vehicle, especially bogie for freight vehicles, where the suspension from the point of view of suspended masses is located as close to the wheelset as possible, so the unsprung masses are minimized, where the suspended masses in the bogie are located as close to the centre of bogie as possible, where the damping is simple and reliable and damping power continuously depends on the load of the car, where the damper does not block the suspension function at ride of empty car and on track with good geometrical quality, where the stiffness of the suspension proportionally increase according to the load of the car, where the suspension design ensure bogie torsional flexibility under condition of usage of rigid bogie frame i.e. suspension design provides wheel forces equalising without parts that may suffer on friction wear and equalization function is not negative influenced by damping device or friction, where all springs of suspension are permanently loaded and rubber is used in suspension, which reduces noise but rubber is not worn by abrasion, where suspension allows to implement standardised bogie - body interface according to UIC and EN, or another interface and the bogie frame uses simplified assembling of bogie frame beams that allows to reduce production and maintenance costs of the bogie, where setting of the bogie height after wheels reprofilation can be done via simple and reliable way without mechanisms permanently assembled in the bogie, where the bogie can be equipped with bolster that hangs on swing hangers and where the bolster not cause significant increase of the wheelbase.

Design of the new bogie according to this invention, particularly freight bogie, is partly based on some existing solutions, wherein the presented bogie suspension assembly has new arrangement, the bogie is equipped with new components thus completely new bogie design is achieved.

The bogie has in base a classic arrangement - with a rigid bogie frame and two wheelsets with wheels. Swing arms couple wheelsets to the bogie frame. Flexible bearing mountings assemble the wheelsets and the swing arms. Bushings assemble the swing arms and the bogie frame. Between the swing arms and the bogie frame are arranged spring assemblies. Direction of the spring strain is nearly horizontal. On one side of the bogie are springs supported by brackets arranged directly on the bogie frame i.e. the reaction forces from suspension springs act directly to the bogie frame structure. On the other side of the bogie, the springs are supported each to other i.e. the spring forces acting on the bogie frame are low.

A new element of the bogie and the main principle of the suspension according to this invention is a damping mechanism, that links the swing arm and suspension and the damping power proportionally derives from car weight, and furthermore new suspended spring equalization support placed on stabilization springs, using to the stabilization spring forces. This suspended support equalize forces in suspension springs without any parts that are subjects of friction wear. There is a new system of bogies height adjustment in the bogie - a system without in the bogie permanently assembled adjustment mechanism, that suffer to permanent vehicle load, wear and corrosion. Further, a new space-saving arrangement of the bolster is performed where the cross beam is arranged in bolster hollow.

The damping mechanism according to this invention is based on a known principle - decomposition of the suspension force Fs achieved by wedges or inclined spring position. Newly, in suspension mechanism consisting of the swing arm and the springs, the component of the spring force - the force F_{P} acts on the wedge or on the suspended equalization support, which pushes on the friction leaf. Due to the motion in the bogie suspension a relative motion of the wedge or of the suspended equalization support against the friction leaf occurs. This motion produces damping friction force F_{F} that damps relative motion of the swing arm against the bogie frame. This arrangement meets the requirement to produce a friction - damping - force F_{F}, that is continuously proportional to forces in the springs assembly i.e. it is proportional to the load of the car. The function of equalising mechanism is in this arrangement newly and advantageous disconnect from any damping effect in the suspension. The correct function of the wedge ensures a bearing plate made as a rubber pad or made as a couple of sliding pads or made as a set of rolling bodies. The friction leaf is possible to possible to assembly in four versions. First - the friction leaf is assembled in to the suspension springs assembly, second - in another embodiment the friction leaf is assembled to the swing arm, third - in another embodiment the friction leaf is assembled to the bogie frame, fourth - in another embodiment the friction leaf is assembled to the suspended equalization support. The friction leaf assembly to the other part can be in all above mentioned versions performed rigid or flexible - by using a flexible joint. The flexibility of the friction leaf joint or flexibility of wedge mounting or flexibility of spring suspension parts, that are coupled in series to the damping system, exclude the malfunction of suspension while the tare vehicle is driving on track with good geometrical quality (at small excitation of suspension).

A new phenomena of the suspension with swing arms according to this invention is the arrangement where the suspension contains at least one spring, or preferably one first spring and one second spring and spring stop, wherein all springs creating the progressive characteristics are permanently loaded in all vehicle loading modes. This eliminates noise produced by unloaded springs. When the spring assembly contains more than one spring, the first springs have lower stiffness than the second one. When the clearance "Δ" to the spring stop at first spring is consumed by car loading, the first springs are not more loaded and only the seconds springs are in suspension operation. This effect advantageously decreases the flexibility of the suspension, i.e. the stiffness of the suspension changes according to weight of the car. This arrangement, where the load of the first spring is limited by spring stop, allows to made first springs small and light in comparison to the second one. This kind of first spring, which not acts behind the brake point of suspension characteristics, is possible to better optimize for operation of empty car or car with low tare weight of vehicle body.

The new suspension according to this invention is designed in order to transfer by swing arms the motion of the wheelset to deflection of the springs where the ratio of the swing arm dimensions "a" and "b" causes, that the deflection of spring is smaller than movement of the wheel. So the spring deflection is proportional to multiplication result of inverted value of the swing arm ratio (b/a) by the value of the vertical movement of the wheelset. The required spring stiffness is than equal to multiplication result of the swing arm ratio in the second power (a/b)² by the value of stiffness required for the wheelset suspension. This is advantageous for usage of rubber springs, because they are naturally appropriate for applications where small deflection and high stiffness is required. Rubber springs has also an attribute of cutting off the metal contact in the way from the wheelset to vehicle body. This rapidly reduces vibrations and emitted noise of the vehicle. Furthermore, the rubber springs produce naturally progressive characteristic already in a simplest rubber spring design - rubber plates layered one on another. This design allows to easy and smoothly change the stiffness according to load of the car. The progressive characteristics of one spring or characteristics of two naturally progressive springs provide considerably better properties of the suspension instead progressive characteristics assembled from linear springs that are current used at freight bogies.

New element and new gist in the bogie suspension according to this invention is an arrangement of suspensions on the side of the bogie, where the spring supports by equalization mechanism. The suspended equalization support is laterally suspended by the stabilization springs, i.e. movable jointed to the bogie frame without friction resistance. Spring assemblies are on this side of the bogie supported by this suspended equalization support that is placed on stabilization springs, that ensure correct working position of the suspended equalization support without using any parts that may suffer to the friction wear. Stabilization springs are in preferred embodiment manufactured as a couple of flat rubber springs arranged cross each to other in inclined positions. Stable position of the suspended equalization support on the stabilization springs ensures permanent acting vertical force F_{V}. This force F_{V} results from spring force decomposition on the inclined spring support interface, where the interface inclined design decompose the spring force on the horizontal and vertical components. The vertical component of the spring force F_{V} pushes the suspended equalization support down on the stabilization springs and stabilize in this way the equalization support position in vertical and lateral direction. Value of the vertical force F_{V} is possible to adjust via geometry of spring inclined interface or via angle of the wedge. This arrangement meets requirement of simple wheel force equalising mechanism providing torsional flexibility of the bogie without rods with friction guidance and without other parts that may suffer from the friction wear and cause hysteresis, which increases the wheel forces changes on twisted track.

New element and another gist in the suspension according to this invention is arrangement and way of changing shims number in the bogie suspension. The shims adjust the height of the bogie in the maintenance. The new arrangement allows change the number of the shims using appropriate force actuator without need to dismount the vehicle body from bogies and without usage of lifting jacks. The shims may be add or removed from the suspension by a mounting device - force actuator that is in the workshop inserted between spring assembly and bogie frame, or between bogie frame and swing arm. The actuator pushes the spring assembly away from the interface, which releases the shims. Then is the number of the released shims changed according to the request. This arrangement fulfils the requirement for simple height adjustment of the bogie performed without bogie dismounting from the car body. The mounting device - force actuator is not assembled in the bogie during operation on the track, so without danger of corrosion damage in operation.

The suspension according to this invention allows the new advantageous arrangement of bogie frame with new assembling of the cross beam and longitudinal beams. These beams are arranged one over the other, i.e. the whole cross beam is arranged above to the longitudinal beams. This allows to assemble these parts with prestressed bolts, i.e. bolts, rivets or huck-bolts. This solution simplifies the machining - avoids the machining of the whole bogie frame, the single beams are machined. This solution also allow to avoid to design welding jig for the whole bogie frame and also the problems with complete bogie frame deformations after welding, because the beams are assembled by bolts and centred by pins to achieve required accuracy. Another advantage comes in the maintenance. It is possible to change only one beam in case of failure of one, which is economically beneficial. The cross beam is arranged on tops of the longitudinal beams and assembled via pre-stressed bolts. These bolts are oriented vertically, i.e. the connection between longitudinal beams and cross beam ensures horizontal planes on the beams that natural carry the vertical load of the bogie frame in optimal direction. The bolts than transfer only shear forces in the bogie frame structure that are significantly lower as the vertical ones. This new solution significantly simplifies the manufacturing and maintenance of the bogie frame under condition of high bogie frames reliability.

New element and another gist of this invention is in the arrangement of the bogie bolster. The cross beam is arranged in the bolster hollow, i.e. the bolster is an open hollow beam and through this bolster hollow is arranged the cross beam. This arrangement is space efficient and solves the redundancy of bolsters hanging in very simple way - the bolster sits on the cross beam in case of the swing hangers failure. This solution advantageously avoids additional save parts for hanging redundancy that have bogies with bolster and swing hangers nowadays. Furthermore, the brake brackets are assembled to the cross beam via vertically oriented pre-stressed bolts. The bolster swing hangers connect the bolster with the brake brackets in this new embodiment - so the car body load acts on the brake brackets interface to the cross beam. This arrangement allows to better optimize the design of the pre-stressed bolts that assemble the cross beam with the brake brackets.

The design of bogies suspension, above described, advantageously decreases unsprung masses, because the suspension is located between wheelset and bogie frame. Furthermore, the suspension design ensures requested dependence between the vehicle load and the suspension stiffness and damping power. Low number of simple and reliable parts arrange the correct function. The components of the suspension are located close to the centre of the bogie, that solution minimize the length of the bogie. Low bogie length enables to optimize design of vehicle body and increase its load capacity. Reduction of the bogie length decreases the weight and the inertia momentum of the bogie, which improves the bogies stability. All suspension springs, which are arranged between wheelset and bogie frame, are permanently loaded. This reduces bogie noise pollution. The suspension damping mechanism does not cause a malfunction of suspension when the tare weight vehicle is running on high quality track. Suspended equalisation support supports the spring assemblies. The spring assemblies push the suspended equalisation support on stabilization springs. This equalisation mechanism does not use parts that may suffer from friction wear, hysteresis and other friction resists. Suspended equalisation support advantageously minimizes the change of the wheel forces on twisted track. This arrangement allows usage of rigid bogie frame that does not warp during operation. The bogie is suitable for UIC bogie-vehicle body interface that allows to interchange bogie according to this invention with other old standardised European bogies. The design of the bogie allows also another bogie - body interface design. The new suspension arrangement allows new bogie frame arrangement, where the cross beam is above the longitudinal beams. Vertically oriented pre-stressed bolts assemble in the horizontal contact planes the bogie frame beams. There is new shim system for bogie height adjustment in the bogie suspension. The new system allows to add or to remove shims without bogie dismantling from car body, the lifting jacks are not necessary. The force actuator is not assembled in the bogie. The bogie is equipped with the hollow bolster with cross beam inside in the bolster, which solution minimize bogie dimensions and weight. Swing hangers connect the brake brackets with bolster hangers, which arrangement improves the load capacity of the bolt connection between brake brackets and bogie frame.

### Brief description of the drawings

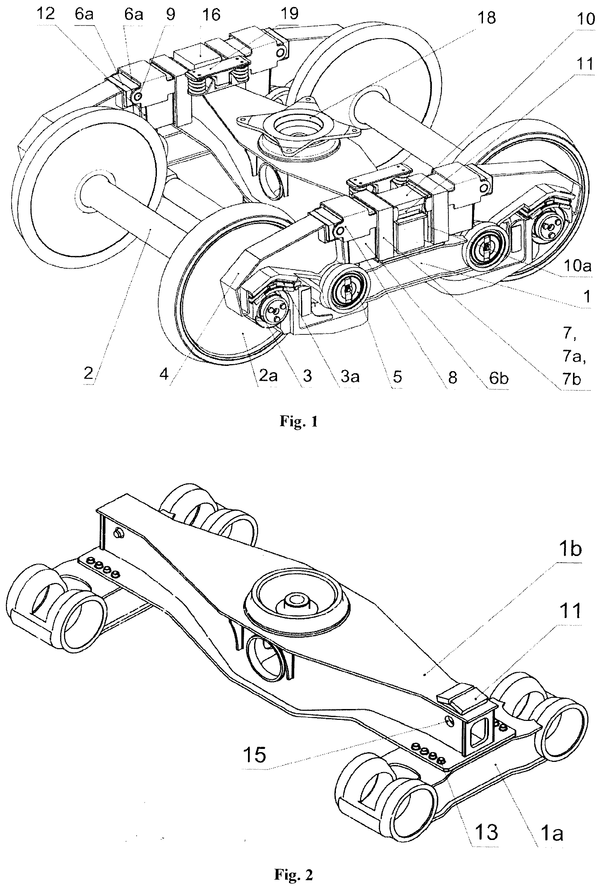

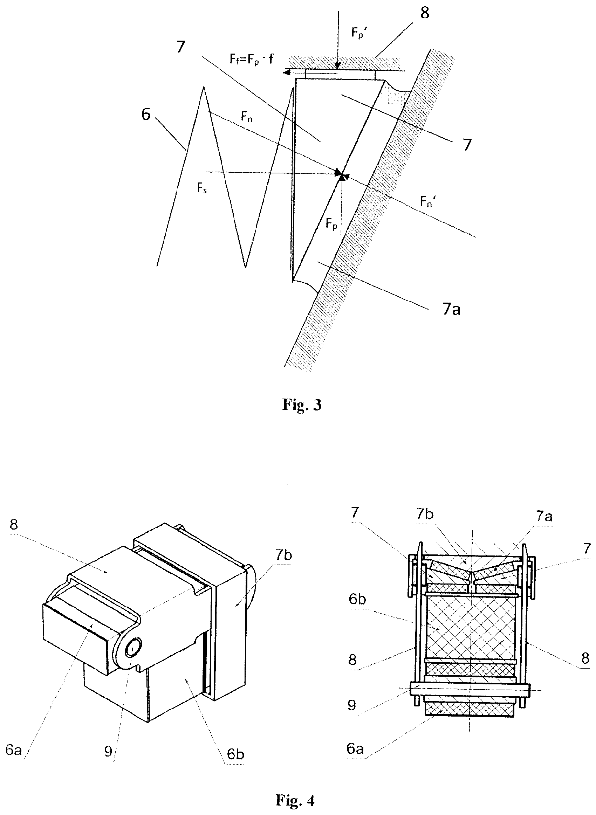

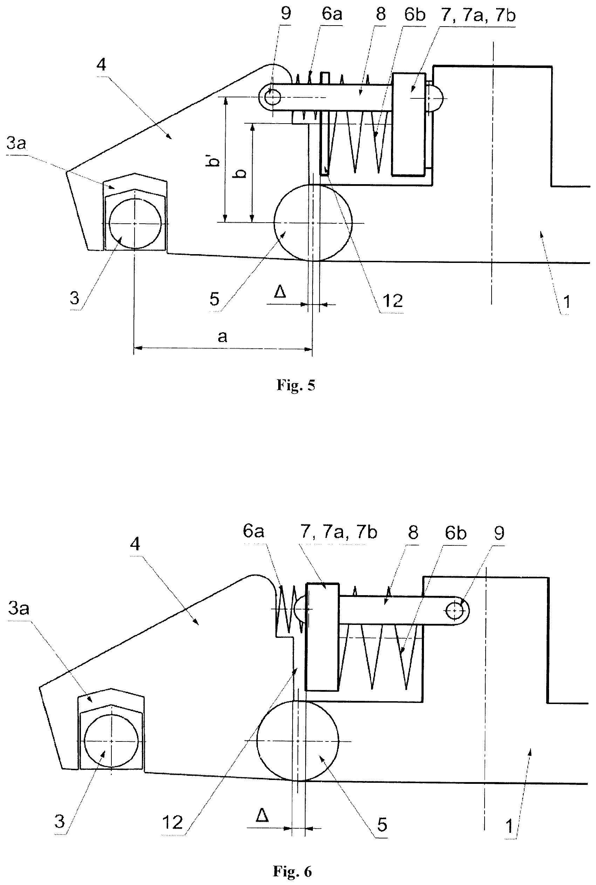

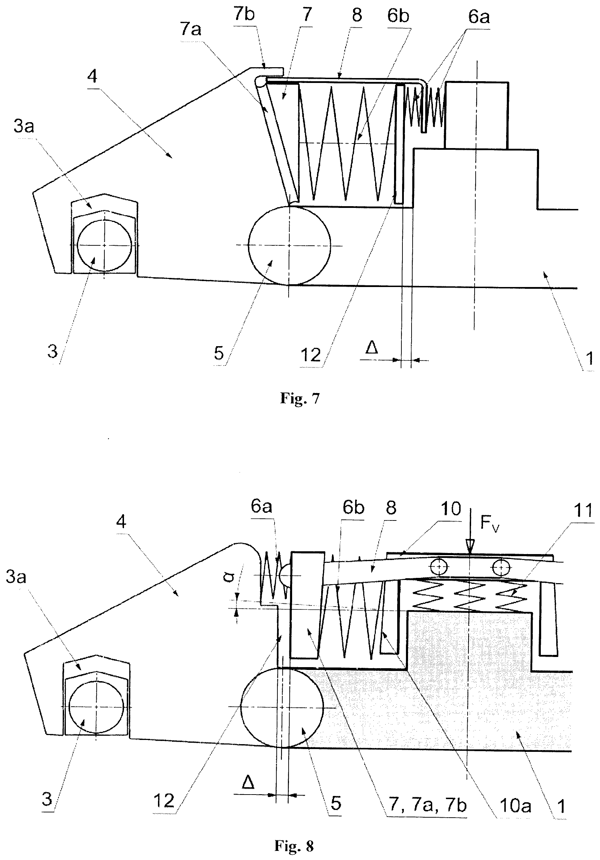

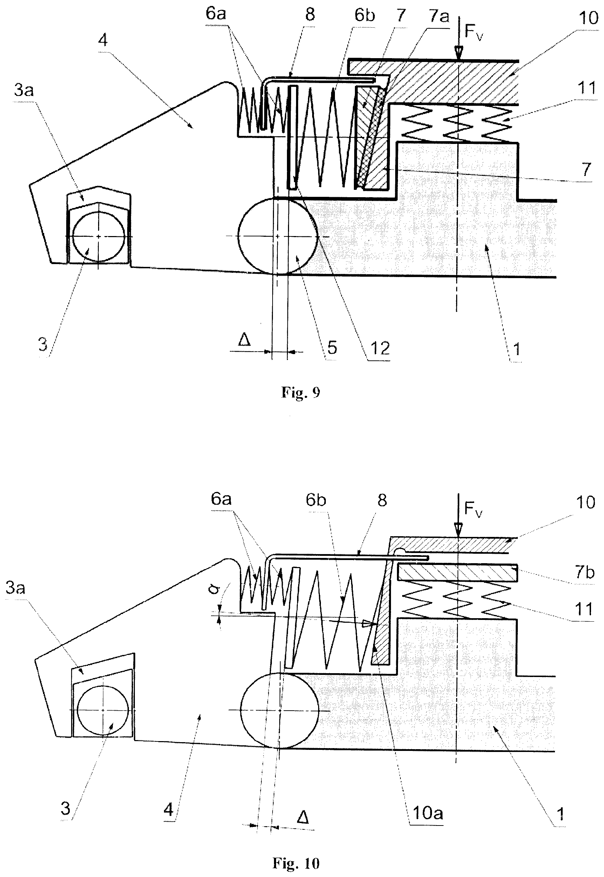

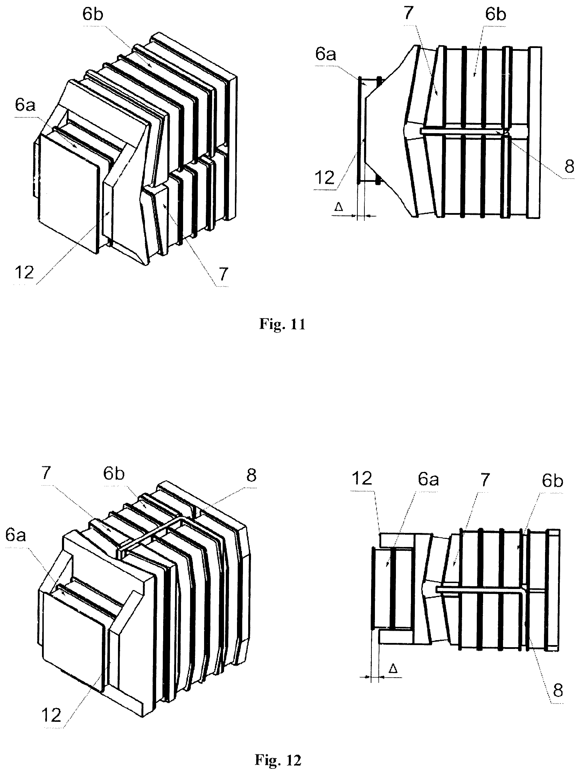

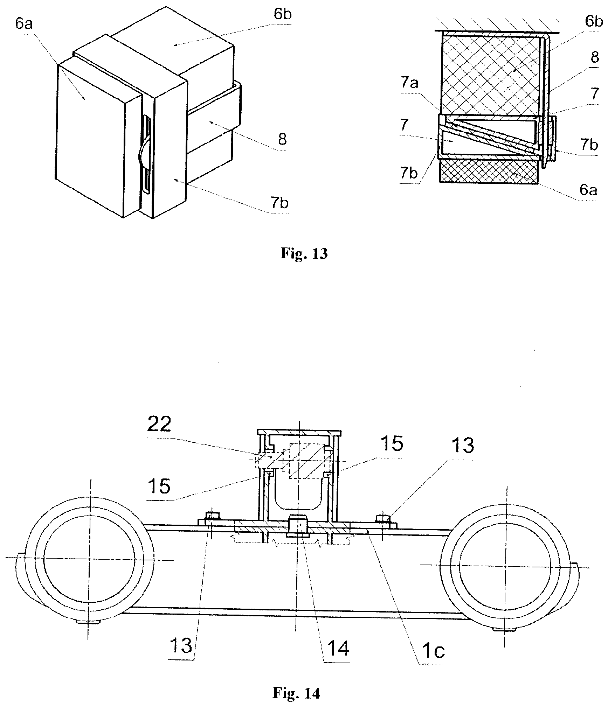

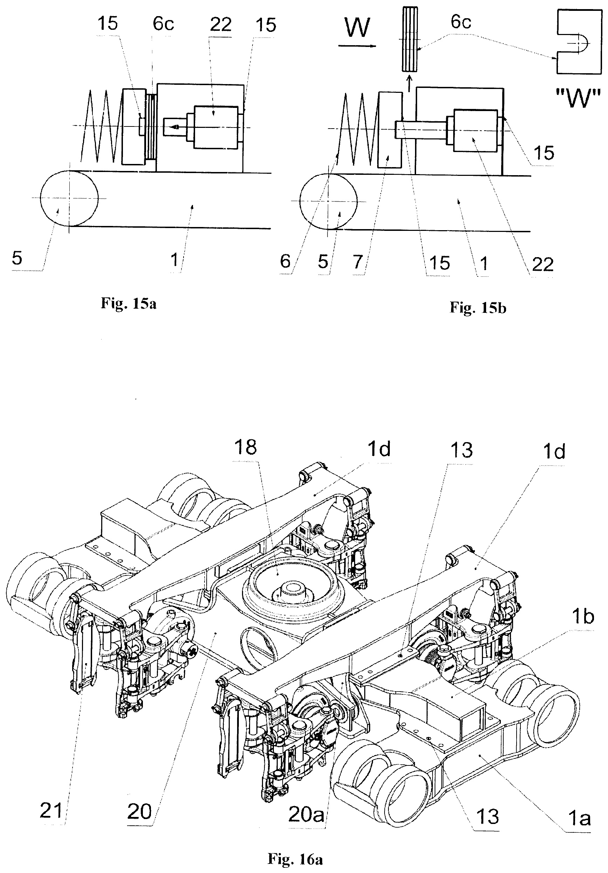

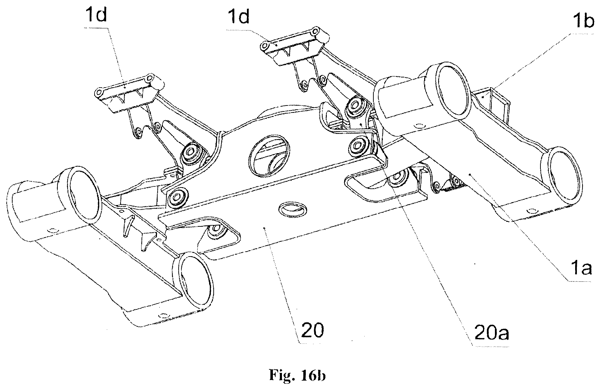

The invention is in more details described on attached figures, fig. 1 shows isometric view of the bogie that is equipped with suspension and damping according to this invention, fig. 2 shows the new bogie frame arrangement where the beams are assembled by pre-stressed bolts and the bogie frame is equipped with inclined stabilization springs, fig. 3 shows principle of force decomposition on damping wedge, fig. 4a shows isometric view of bogie damping mechanism, fig. 4b shows cut section of the damping mechanism, fig. 5 to fig. 10 show schematic views of examples of the suspension, damping, equalizing and stabilization mechanism arrangement, where fig. 5 shows friction leaf assembled to the swing arm, fig. 6 shows friction leaf assembled to the bogie frame, fig. 7 shows friction leaf connection integrated in to the spring assembly, fig. 8 shows friction leaf assembled to the suspended equalization support, fig. 9 shows friction leaf integrated in to the suspension spring assembly and into the suspended equalization support wedge, fig. 10 shows friction leaf connection integrated into the suspension spring assembly, fig. 11 to fig. 13 show examples of arrangement of the springs, wedges and friction leaf, wherein fig. 11a shows isometric view of the springs with horizontally oriented friction leaf that is located between suspension springs, fig. 11b shows side view of this arrangement, fig. 12a shows isometric view of the springs with vertically oriented friction leaf between suspension springs, fig. 12b shows side view of this arrangement, fig. 13a shows isometric view of friction leaf that are arranged along the suspension springs, fig. 13b shows cut section of this arrangement, fig. 14 shows schematic view of the cross beam assembly with the longitudinal beam and insertion of the maintenance force actuator, fig. 15 shows schematic view of the bogies height regulation using force actuator and shims, where fig. 15a shows force actuator switched off by insert in to the bogie and fig. 15b shows force actuator switched on and acting on springs, fig 16 shows isometric view of the hollow bolster arrangement with swing hangers and brake consoles, wherein fig 16a is a top view and fig. 16b is bottom view.

### Examples of the invention embodiment

Attached figures show arrangement of the railway bogie. The bogie has a rigid bogie frame 1 and two wheelsets 2 with wheels 2a. The swing arms 4 couple wheelsets 2 to the bogie frame 1, where bearings 3 and bearings springs 3a assemble the wheelsets to swing arms 4. Bushings 5 assemble swing arms 4 with the bogie frame 1. Spring assemblies 6 and wedges 7 and friction leafs 8 and spring stop 12 and on one side of the bogie arranged suspended equalization support 10 are mounted between the swing arms 4 and bogie frame 1.

Spring force F_{S} from spring assemblies 6 act on to the wedges 7 and on to suspended equalization support 10, where the wedge decompose the force into components Fₙ and F_{P} and where the support interface 10a decompose the force F_{S} into components F_{P} and F_{V}. The force F_{P} is a pressure force that acts on the wedge 7. The force F_{V} is a pressure force that vertical acts on the suspended equalization support 10. The pressure force F_{P} is internal force in the damping mechanism so this force does not strain the bogie frame 1. The force F_{V} force acts on suspended equalization support 10 and stabilization springs 11 arranged on the bogie frame 1. This effect leads to stabilization of suspended equalization support 10, in working position. Stirrup 7b react the force F_{P}. The force F_{P} and its reaction clasp the friction leaf8. So the movement in the suspension during the operation creates a friction force F_{F} on the friction leaf 8. The force F_{F} damps the motion of the swing arm 4, so damps dynamical movements in the suspension. Movability of wedges 7 ensure bearing plate 7a that is arranged at the wedge 7 or between the wedges 7. The bearing plate 7a is rubber plate. Reaction of the friction force F_{F} is supported by a joint 9 on the friction leaf 8. The joint 9 is integrated in the spring 6a. Flexibility of the joint 9 and a flexibility of the springs 6a prevent the malfunction of the suspension when the vehicle is running on track with good geometrical quality.

Advantageously, the construction can be provide so that the joint of friction leaf 8 may be inserted directly into the suspension spring assembly 6 or between the suspension springs 6 and its interface or it may be equipped with a joint 9. Fixation of the joint 9 of the friction leaf 8 may be performed as follows - the joint 9 is on swing arm 4, or the joint 9 is on the bogie frame 1, or the joint 9 is on the suspended equalization support 10. The joint 9 flexibility prevents the malfunction of the suspension in these solutions.

Advantageously, the friction leaf 8 may be oriented vertically or horizontally and further it may be arranged inside the springs of spring assembly 6 or next to the suspension spring assembly 6.

Spring assembly 6 contains first springs 6a, second springs 6b , spring stop 12 and shims 6c, whereas the first springs 6a and second springs 6b are in a series arrangement. There is a free clearance Δ between the spring stop 12 and swing arm 4 or between the spring stop 12 and bogie frame 1 in case of empty car. Due to the vehicle load increase the clearance Δ is gradually consumed. The loading of the spring 6a stops when the clearance Δ is fully consumed. All springs in the spring assembly 6 are permanently loaded through the whole vehicle load range. This spring 6a has lower stiffness and smaller dimensions than second spring 6b - advantageously, relative position of the first springs 6a to the position of second springs 6b can be such that the spring 6a is on maximum radius relative to bushes 5.

The suspension springs 6 are manufactured in the simplest possible design - rubber plates layered one on another. The first springs 6a and the second springs 6b are naturally progressive. The spring stop 12 - break point of the characteristics - and natural rubber progressivity perform requested smoothly progressive characteristics.

Springs 6 of the suspension arranged at the swing arms 4 are rigidly supported on one side of the bogie on the cross beam 1b. So the spring forces Fs acts directly on to the bogie frame 1 on this bogie side. The suspended equalization support 10 is arranged on stabilization springs 11 on the other side of the bogie. The inclined interface 10a that is located on the suspended equalization support 10 supports the suspensions springs 6. Cross arrangement of two inclined stabilization springs 11 ensure, that their lateral stiffness minimally influences the function of the equalisation mechanism. This means, the stabilization springs 11 are designed to have a negligible stiffness in bogie longitudinal direction. The couple of cross inclined stabilization springs 11 have considerable stiffness in vertical direction and in cross-lateral direction. This ensures working stability of the suspended equalization support 10, which is permanently pushed on stabilization springs 11 via force F_{V}, which is generate by decomposition of the spring force F_{S} due to the inclined position of at least one spring from the suspension spring assembly 6 or due to the wedge 7.

An interface 15 is arranged on the bogie frame 1, that allows to insert a mounting device - force actuator 22 - between the springs 6 and its interface. The force actuator 22 allows to push the spring assembly 6 away from the bogie frame 1, which allows to add or tov remove shims 7c. This process ensures required height of the bogie.

Longitudinal beams 1a of the bogie frame 1 are equipped with horizontal contact planes 1c. The cross beam 1b of the bogie frame 1 is also equipped with the horizontal contact planes 1c. The cross beam 1b is arranged above the longitudinal beams 1a in the bogie frame 1 assembly, where the beams mutual positon is defined by centre pins 14. The beams are assembled by pre-stressed bolts 13, for example Huck-Bolts.

The cross beam 1b is arranged in the bolster 20 hollow. The bolster 20 hang on inclined swing hangers 20a. The upper ends of swing hangers 20a are jointed to brake brackets 1d. The brake brackets 1d carry brake 21. The brake bracket 1d and cross beam 1b of the bogie frame 1 are assembled by pre-stressed bolts 13, for example Huck-bolts.

The bogie is equipped with mechanical link 17 between wheelsets 2. The bogie is equipped with load sensor 16. The bogie is equipped with UIC standardised bogie-body interface that consists from pivot bearing 18 and side bearers 19.

### Industrial applicability

The bogie that is equipped with a suspension, a damping, a bogie frame and a bolster according the description is to use in any railway vehicle, especially in freight railway vehicles.

## Claims

1. A railway vehicle bogie, in particular for a freight car, comprising a bogie frame (1) and at least two wheelsets (2) with wheels (2a) coupled to the bogie frame (1) by swing arms (4), which are assembled to the wheelsets (2) by bearings (3) and flexible bearing mountings (3a), wherein the swing arms (4) are assembled with the bogie frame (1) by bushings (5) and by suspension springs assemblies (6) arranged between the swing arms (4) and bogie frame (1) whereby in at least one assembly comprising a swing arm (4) and a suspension spring assembly (6), consisting of at least one spring (6a,6b), a friction damping system of movement between the swing arm (4) and the bogie frame (1) is arranged, wherein the intensity of damping effect depends on the magnitude of transmitted force in the suspension springs assembly (6), i.e. load of the car, wherein the friction damping system comprises the suspension spring assembly (6) and at least one wedge (7), loaded with the at least one spring (6a,6b) contained in the suspension spring assembly (6) and at least one friction leaf (8) that is loaded by a the wedge (7) **characterized in that**
the direction of the spring strain of the spring assembly (6) is nearly horizontal.

2. The railway vehicle bogie, in particular for a freight car, comprising a bogie frame (1) and at least two wheelsets (2) with wheels (2a) coupled to the bogie frame (1) by swing arms (4), which are assembled to the wheelsets (2) by bearings (3) and flexible bearing mountings (3a), and on one side of the bogie suspended equalization support (10) mounted between the swing arms (4) and bogie frame (1), wherein the swing arms (4) are assembled with the bogie frame (1) by bushings (5) and by springs assemblies (6) arranged between the swing arms (4) and bogie frame (1), whereby in at least one assembly comprising a swing arm (4) and a suspension springs assembly (6), consisting of at least on spring (6a, 6b), a friction damping system of movement between the swing arm (4) and the bogie frame (1) is arranged, wherein the intensity of damping effect depends on the magnitude of transmitted force in the springs assembly (6), i.e. load of the car, wherein said friction damping system comprises the suspension spring assembly (6), where at the least one spring (6a, 6b) is supported by inclined an inclined interface (10a) on the suspended equalization support (10) and at least one friction leaf (8), loaded by the one suspended equalization support (10)
**characterized in that**
the direction of the spring strain of the spring assembly (6) is nearly horizontal.

3. The bogie according to claim 1 or 2 **characterized in that** at least one friction leaf (8) assembled to the suspension springs assembly (6).

4. The bogie according to claim 1 or 2 **characterized in that** at least one friction leaf (8) is assembled to the bogie frame (1).

5. The bogie according to claim 1 or 2 **characterized in that** at least one friction leaf (8) is assembled to the suspended equalization support (10).

6. The bogie according to claim 2 **characterized in that** at least one friction leaf (8) is assembled to the swing arm (4).

7. The bogie according to any of claims 1 to 6 **characterized in that** at least one spring from suspension spring assembly (6) is made from rubber.

8. The bogie according to any of claims 1 to 7 **characterized in that** the suspension spring assembly (6) comprises at least one first spring (6a) and at least one second spring (6b).

9. The bogie according to any of claims 2 or 3-8 when dependent from claim 2 **characterized in that** the suspended equalization support (10) is assembled at least at one side of the bogie travelling in the longitudinal direction, which is equipped with inclined arranged interface (10a) to support at least one spring from suspension spring assembly(6) and said movable equalization support (10) travelling in the longitudinal direction is mounted on at least one stabilization spring (11) mounted on the bogie frame (1).

10. The bogie according to any of claims 1 to 9 **characterized in that** a set of shims (6c) is arranged in spring assembly (6) to adjust the bogie and furthermore, the bogie comprises at least one interface (15) for a mounting a device (22), by the force of which the suspension spring assembly (6) is pushed away, thus modifications of the shim number (6c) also in the bogie under the car is possible.

11. The bogie according to any of claims 1 to claims 10 **characterized in that** a cross beam (1b) is arranged above longitudinal beam (1a) of the bogie frame (1), and the cross beam (1b) and at least one longitudinal beam (1a) are assembled in the horizontal contact plane (1c) by vertically oriented pre-stressed bolts (13).

12. The bogie according to claim 11 **characterized in that** the cross beam (1b) of the bogie frame (1) is arranged inside the bolster (20) hollow.

13. The bogie according to any of claims 11 to 12 **characterized in that** at least one brake bracket (1d) of a brake (21) is assembled to the cross beam (1b) of the bogie frame (1), by pre-stressed bolts (13) and swing hangers (20a) are with one end attached to the brake bracket (1d) of the brake (21).

## Patentansprüche

1. Fahrgestell eines Schienenfahrzeugs, insbesondere für einen Güterwagen, enthaltend einen Fahrgestellrahmen (1) und mindestens zwei Radsätze (2) mit Rädern (2a), die mit dem Fahrgestellrahmen (1) über Schwingarme (4) verbunden sind, welche an den Radsätzen (2) mittels Lagerungen (3) und elastischen Lagerungen (3a) angebaut sind, wobei der Schwingarm (4) mit dem Fahrgestellrahmen (1) durch Buchsen (5) und zwischen den Schwingarmen (4) und dem Fahrgestellrahmen (1) angeordnete Federbaugruppen (6) verbunden ist, wobei in mindestens einer Baugruppe, bestehend aus einem Schwingarm (4) und einer Federbaugruppe (6), die aus mindestens einer Feder (6a, 6b) besteht, ein Reibungsdämpfungssystem für die Bewegung zwischen Schwingarm (4) und Fahrgestellrahmen (1) angeordnet ist, wobei die Intensität der Dämpfungswirkung von der in der Federbaugruppe (6) übertragenen Kraft, also von der Wagenlast, abhängt, wobei das Reibungsdämpfungssystem die Federbaugruppe (6) und mindestens einen Keil (7) enthält, der von mindestens einer in der Federbaugruppe (6) der Federung enthaltenen Feder (6a, 6b) belastet ist, und mindestens eine Reibungsplatte (8), die vom Keil (7) belastet wird, **dadurch gekennzeichnet, dass** die Spannungsrichtung der Federn der Federbaugruppe (6) annähernd horizontal ist.

2. Fahrgestell eines Schienenfahrzeugs, insbesondere für einen Güterwagen, enthaltend einen Fahrgestellrahmen (1) und mindestens zwei Radsätze (2) mit Rädern (2a), die mit dem Fahrgestellrahmen (1) durch Schwingarme (4) verbunden sind, die mit den Radsätzen (2) durch Lagerungen (3) und elastische Lagerlagerungen (3a) zusammengesetzt sind, und an einer Seite des Fahrgestells eine aufgehängte Ausgleichsstütze (10), die zwischen den Schwingarmen (4) und dem Fahrgestellrahmen (1) montiert ist, wobei die Schwingarme (4) mit dem Fahrgestellrahmen (1) durch Buchsen (5) und zwischen den Schwingarmen (4) und dem Fahrgestellrahmen (1) angeordnete gefederte Federbaugruppen (6) verbunden sind, wobei in mindestens einer Baugruppe, die einen Schwingarm (4) und einer Federbaugruppe (6), die aus mindestens einer Feder (6a, 6b) besteht, ein Reibungsdämpfungssystem für die Bewegung zwischen dem Schwingarm (4) und dem Fahrgestellrahmen (1) angeordnet ist, wobei die Intensität der Dämpfung von der in der Federbaugruppe (6) übertragenen Kraft, d.h. von der Wagenlast, abhängt, wobei das Reibungsdämpfungssystem die Federbaugruppe (6) enthält, wobei mindestens eine Feder (6a, 6b) an einer geneigten Schnittstelle (10a) der aufgehängten Ausgleichsstütze (10) abgestützt ist und mindestens eine Reibungsplatte (8) vorgesehen ist, die von der aufgehängten Ausgleichsstütze (10) belastet wird, **dadurch gekennzeichnet, dass** die Spannungsrichtung der Federn der Federbaugruppe (6) annähernd horizontal ist.

3. Fahrgestell nach Anspruch 1 oder 2, **dadurch gekennzeichnet, dass** an der Federbaugruppe (6) mindestens eine Reibungsplatte (8) angebracht ist.

4. Fahrgestell nach Anspruch 1 oder 2, **dadurch gekennzeichnet, dass** am Fahrgestellrahmen (1) mindestens eine Reibungsplatte (8) angebracht ist.

5. Fahrgestell nach Anspruch 2, **dadurch gekennzeichnet, dass** an der aufgehängten Ausgleichsstütze (10) mindestens eine Reibungsplatte (8) angebracht ist.

6. Fahrgestell nach Anspruch 1 oder 2, **dadurch gekennzeichnet, dass** am Schwingarm (4) mindestens eine Reibungsplatte (8) angebracht ist.

7. Fahrgestell nach einem der Ansprüche 1 bis 6, **dadurch gekennzeichnet, dass** mindestens eine Feder (6a, 6b) der Federbaugruppe (6) aus Gummi hergestellt ist.

8. Fahrgestell nach einem der Ansprüche 1 bis 7, **dadurch gekennzeichnet, dass** die Federbaugruppe (6) mindestens eine erste Feder (6a) und mindestens eine zweite Feder (6b) enthält.

9. Fahrgestell nach einem der Ansprüche 2 oder 3 bis 8 in Abhängigkeit von Anspruch 2, **dadurch gekennzeichnet, dass** die aufgehängte Ausgleichsstütze (10) an mindestens einer in Längsrichtung beweglichen Seite des Fahrgestells montiert ist, die mit einer geneigten Schnittstelle (10a) zur Abstützung von mindestens einer Feder der Federbaugruppe (6) ausgestattet ist, und dass die sich in Längsrichtung bewegende aufgehängte Ausgleichsstütze (10) auf mindestens einer am Fahrgestellrahmen (1) montierten Stabilisierungsfeder (11) gelagert ist.

10. Fahrgestell nach einem der Ansprüche 1 bis 9, **dadurch gekennzeichnet, dass** in der Federbaugruppe (6) ein Satz Unterlegscheiben (6c) zur Einstellung des Fahrgestells angeordnet ist und das Fahrgestell ferner mindestens eine Schnittstelle (15) für die Montage einer Vorrichtung (22) enthält, deren Kraft die Federbaugruppe (6) abdrückt, wodurch eine Anpassung der Anzahl der Unterlegscheiben (6c) auch im eingebauten Zustand unter dem Wagen möglich ist.

11. Fahrgestell nach einem der Ansprüche 1 bis 10, **dadurch gekennzeichnet, dass** über dem Längsträger (la) des Fahrgestellrahmens (1) ein Querträger (1b) und ein Querträger (1b) und mindestens ein Längsträger angeordnet sind. Die Träger (la) sind in einer horizontalen Kontaktebene (lc) mittels vertikal orientierter vorgespannter Schrauben (13) zusammengebaut.

12. Fahrgestell nach Anspruch 11, **dadurch gekennzeichnet, dass** der Querträger (lb) des Fahrgestellrahmens (1) in einer Wiegenaussparung (20) angeordnet ist.

13. Fahrgestell nach einem der Ansprüche 11 bis 12, **dadurch gekennzeichnet, dass** mindestens ein Bremskonsole (1d) der Bremse (21) am Querträger (1b) des Fahrgestellrahmens (1) durch vorgespannte Schrauben (13) montiert ist und die Schwingaufhängungen (20a) mit einem Ende an der Bremskonsole (1d) der Bremse (21) befestigt sind.

## Revendications

1. Le châssis d'un véhicule ferroviaire, en particulier pour un wagon, comprenant le châssis de bogie (1) et au moins deux essieux montés (2) avec des roues (2a) reliées au châssis de bogie (1) au moyen de bras oscillants (4), lesquels sont montés sur les essieux montés (2) à l'aide de roulements (3) et de supports élastiques (3a), où le bras oscillant (4) est fixé au châssis de bogie (1) par des manchons (5) et des ensembles de ressorts de suspension (6) disposés entre les bras oscillants (4) et le châssis de bogie (1), **caractérisé en ce que** dans au moins un ensemble comprenant le bras oscillant (4) et l'ensemble de ressorts de suspension (6) composé d'au moins un ressort (6a, 6b), le système d'amortissement par friction est disposé pour le mouvement entre le bras oscillant (4) et le châssis de bogie (1), l'intensité de l'effet d'amortissement dépendant de l'ampleur de la force transmise dans l'ensemble de ressorts de suspension (6), c'est-à-dire de la charge du véhicule, le système d'amortissement par friction comprenant l'ensemble de ressorts de suspension (6) et au moins un coin (7) chargé par au moins un ressort (6a, 6b) contenu dans l'ensemble de ressorts de suspension (6) et au moins une plaque de friction (8) chargée par le coin (7), **caractérisé en ce que** la direction de tension des ressorts de l'ensemble de suspension (6) est pratiquement horizontale.

2. Le châssis d'un véhicule ferroviaire, en particulier pour un wagon, comprenant le châssis de bogie (1) et au moins deux essieux montés (2) avec des roues (2a) reliées au châssis de bogie (1) au moyen de bras oscillants (4), qui sont assemblés en essieux montés (2) à l'aide de roulements (3) et de supports élastiques (3a), et, d'un côté du châssis, le support de nivellement suspendu (10), monté entre les bras oscillants (4) et le châssis de bogie (1), où les bras oscillants (4) sont reliés au châssis de bogie (1) par des manchons (5) et des ensembles de ressorts de suspension (6) disposés entre les bras oscillants (4) et le châssis de bogie (1), **caractérisé en ce que**, dans au moins un ensemble comprenant un bras oscillant flottant (4) et un ensemble de ressorts de suspension (6), composé d'au moins un ressort (6a, 6b), un système d'amortissement par friction est disposé pour le mouvement entre le bras oscillant flottant (4) et le châssis de bogie (1), dans lequel l'intensité de l'effet d'amortissement dépend de l'ampleur de la force transmise dans l'ensemble de ressorts de suspension (6), c'est-à-dire de la charge du véhicule, où ledit système d'amortissement par friction comprenant l'ensemble de ressorts de suspension (6), dans lequel au moins un ressort (6a, 6b) est supporté par une interface inclinée (10a) sur un support de nivellement suspendu (10), et au moins un frottement (8) chargé par le support de nivellement suspendu (10), **caractérisé en ce que** la direction de tension des ressorts de l'ensemble de suspension (6) est pratiquement horizontale.

3. Le châssis selon la revendication 1 ou 2, **caractérisé en ce qu'**au moins une lame de frottement (8) est montée sur l'ensemble de ressorts de suspension (6).

4. Le châssis selon la revendication 1 ou 2, **caractérisé en ce qu'**au moins une lame de frottement (8) est montée sur le châssis de bogie (1).

5. Le châssis selon la revendication 2, **caractérisé en ce qu'**au moins une lame de frottement (8) est montée sur le support de nivellement suspendu (10).

6. Le châssis selon la revendication 1 ou 2, **caractérisé en ce qu'**au moins une lame de frottement (8) est montée sur le bras oscillant (4)

7. Le châssis selon l'une des revendications 1 à 6, **caractérisé en ce qu'**au moins un ressort (6a, 6b) de l'ensemble de ressorts de suspension (6) est en caoutchouc.

8. Le châssis selon l'une des revendications 1 à 7, **caractérisé en ce que** l'ensemble de ressorts de suspension (6) comprend au moins un premier ressort (6a) et au moins un second ressort (6b).

9. Le châssis selon l'une quelconque des revendications 2 ou 3 à 8 dépendant de la revendication 2, **caractérisé en ce que** le support de nivellement suspendu (10) est monté au moins sur un côté du châssis se déplaçant dans la direction longitudinale, lequel est pourvu d'une interface inclinée (10a) pour supporter au moins un ressort de l'ensemble de ressorts de suspension (6), et **en ce que** ledit support de nivellement suspendu (10) se déplaçant dans la direction longitudinale, est monté au moins sur un ressort de stabilisateur (11) monté au châssis de bogie (1).

10. Le châssis selon l'une quelconque des revendications 1 à 9, **caractérisé en ce que** l'ensemble de ressorts (6) comprend un jeu de cales (6c) pour le réglage du châssis, et **en ce que** le châssis comprend en outre au moins une interface (15) pour le montage d'un dispositif (22), par la force duquel l'ensemble de ressorts de suspension (6) est repoussé, permettant ainsi un réglage du nombre de cales (6c) même dans le châssis sous le véhicule.

11. Le châssis selon l'une quelconque des revendications 1 à 10, **caractérisé en ce qu'**une traverse (1b) et une traverse (1b) et au moins un longeron sont disposés au-dessus du longeron (Ia) du châssis de bogie (1). Les longerons (Ia) sont assemblés dans un plan de contact horizontal (Ic) au moyen de boulons précontraints orientés verticalement (13).

12. Le châssis selon la revendication 11, **caractérisé en ce que** la traverse (lb) du châssis de bogie (1) est disposée dans une cavité de berceau (20).

13. Le châssis selon l'une quelconque des revendications 11 à 12, **caractérisé en ce qu'**au moins une console de frein (Id) du frein (21) est montée sur la traverse (Ib) du châssis de bogie (1) au moyen de boulons précontraints (13), et **en ce que** des suspensions oscillantes (20a) sont fixées par une de leurs extrémités au support de frein (1d) du frein (21).
